# EUROPÄISCHE PATENTSCHRIFT

(11) **EP 1 590 644 B1**
(45) Veröffentlichungstag und Bekanntmachung des Hinweises auf die Patenterteilung: **09.08.2006**
(21) Anmeldenummer: 03753322.1
(22) Anmeldetag: 23.09.2003
(51) Int. Cl.: G01L 9/00, H01L 41/00, H01L 21/20

(54) **MIKROMECHANISCHES SENSOR UND VERFAHREN ZU DESSEN HERSTELLUNG**
MICROMECHANICAL SENSOR AND METHOD FOR PRODUCTION THEREOF
CAPTEUR MICROMECANIQUE ET SON PROCEDE DE PRODUCTION

(30) Priorität: 24.01.2003 DE 10302676
(43) Veröffentlichungstag der Anmeldung: 02.11.2005
(73) Patentinhaber: ROBERT BOSCH GMBH, 70442 Stuttgart (DE)
(72) Erfinder: LUTZ, Markus, Palo Alto, CA 94304 (US); FISCHER, Frank, 72810 Gomaringen (DE)
(86) Internationale Anmeldenummer: PCT/DE2003/003151
(87) Internationale Veröffentlichungsnummer: WO 2004/070338

(56) Entgegenhaltungen:
- EP-A- 0 890 998
- EP-A- 1 049 157

## Beschreibung

Die Erfindung betrifft ein mikromechanisches Bauelement, insbesondere einen Drucksensor, bestehend aus einem Siliziumsubstrat mit einer darauf abgeschiedenen Epitaxieschicht mit gleichzeitig nebeneinander aufgewachsenem monokristallinen und polykristallinen Silizium, wobei durch einen Ätzprozess ein Bereich der Epitaxieschicht als vertikal auslenkbare Membran freigelegt ist, und wobei die Epitaxieschicht in einem etwa dem Membran-Bereich entsprechenden Bereich aus polykristallinem Silizium besteht, das zu beiden Seiten der Membran in monokristallines Silizium übergeht, wodurch Übergangsbereiche gebildet sind.

Ein derartiges Bauelement und ein entsprechendes Verfahren sind bereits aus der Offenlegungsschrift DE 43 18 466 A1 bekannt. Zur Herstellung wird dort vorgeschlagen, eine Siliziumoxidschicht als Opferschicht auf das Siliziumsubstrat aufzubringen und anschließend eine Epitaxieschicht aufzubringen, wobei diese oberhalb der Opferschicht polykristallin und seitlich davon, auf dem Substrat, monokristallin aufwächst.

Obwohl auf beliebige mikromechanische Bauelemente mit derartigen epitaktischen Membran-Strukturen anwendbar, werden die vorliegende Erfindung sowie die ihr zu Grunde liegende Problematik in Bezug auf einen in der Technologie der Silizium-Oberflächenmikromechanik herstellbaren mikromechanischen Drucksensor mit piezoresistiven Widerstandselementen erläutert.

Mikromechanische Drucksensoren, bei denen piezoresistive Widerstandselemente auf einer Silizium-Membran angeordnet sind, so dass ihr elektrischer Widerstand sich aufgrund der Verformung der Membran ändert, sind an sich bekannt. Bei der piezoresistiven Messwertaufnahme besteht jedoch, anders als beispielsweise bei mikromechanischen Drucksensoren mit kapazitivem Messprinzip, für rauscharme Messungen die wesentliche Voraussetzung, dass die Widerstandselemente in monokristallines Silizium integriert sind.

Diese Voraussetzung ist mit gattungsgemäßen Bauelementen, bei denen die Membran aus polykristallinem Silizium besteht, bisher nicht kompatibel.

Aus der DE 195 26 691 A1 ist es im Zusammenhang mit einem Verfahren zur Herstellung von Sensoren mit gleichzeitiger epitaktischer Abscheidung von polykristallinem und monokristallinem Silizium im Übrigen bekannt, dass das Wachstum der Epitaxieschicht auf einem Siliziumsubstrat mit einer darauf aufgebrachten Opferschicht derart erfolgt, dass sich der polykristalline Bereich mit schrägem Profil noch ein wenig zu beiden Seiten der Opferschicht, also über den Membran-Bereich hinaus, erstreckt. In Anbetracht dessen scheint es von vornherein noch sicherer zu sein, dass die epitaktische Membran einer piezoresistiven Auswertung nicht zugänglich ist.

Aus der EP 0 890 998 A 1 ist ein Drucksensor mit einer polykristallinen Membran aus einem Halbleitermaterial bekannt. Zur Herstellung dieses Drucksensors wird auf ein Siliziumsubstrat eine Epitaxieschicht aufgebracht, die sowohl polykristalline als auch monokristalline Bereiche aufweist. Die Membran des Drucksensors wird dabei durch die Entfernung einer Opferschicht und die Bildung eines Luftspalts unterhalb der polykristallinen Schicht erzeugt.

Der Erfindung liegt die Aufgabe zugrunde, ein mikromechanisches Bauelement der eingangs genannten Art so weiterzubilden bzw. ein dementsprechendes Herstellungsverfahren anzugeben, dass das Bauelement einer piezoresistiven Auswertung zugänglich wird.

Diese Aufgabe wird bei einem mikromechanischen Bauelement der eingangs genannten Art dadurch gelöst, dass die Übergangsbereiche von polykristallinem zu monokristallinem Silizium jeweils ein schräges Profil aufweisen, derart, dass sich das monokristalline Silizium in Form eines Überhangs oberhalb des polykristallinen Siliziums in den Membran-Bereich hinein erstreckt, und daß die Meßelemente auf der Membranoberseite im Bereich des monokristallinen überhangs aufgebracht werden können.

In den Unteransprüchen finden sich vorteilhafte Weiterbildungen und Verbesserungen des in Anspruch 1 angegebenen Bauelementes.

Die der vorliegenden Erfindung zugrunde liegende Idee besteht darin, das Aufwachsen der Epitaxieschicht auf der Basis einer Topografie durchzuführen, bei der, umgekehrt wie bisher, der Bereich der Opferschicht gegenüber den monokristallinen seitlichen Silizium-Bereichen abgesenkt ist, so dass das monokristallin aufwachsende Silizium das auf die Opferschicht aufwachsende polykristalline Silizium in einem in der Peripherie des Membran-Bereiches gelegenen Übergangsbereich in der Art eines Überhangs lateral überwächst. Die im Volumen, wie bisher, aus epitaktisch aufgewachsenem polykristallinen Silizium bestehende Membran weist deshalb aufgrund der in die Peripherie hinein reichenden Überhänge vorteilhafterweise von der Oberseite der Membran her zugängliche monokristalline Teilbereiche, eben die Überhänge, auf.

In einer vorteilhaften Weiterbildung der Erfindung kann deshalb das Bauelement als Sensor ausgebildet sein und es können Mittel zur Auswertung der Auslenkung der Membran vorgesehen sein, wobei mindestens ein Messelement zur Messung der Auslenkung an der Membranoberseite, im Bereich des monokristallinen Überhangs, angeordnet ist.

Dadurch ist die Realisierung der Messeelemente auf bzw. in der Membran nicht mehr auf polykristallines Silizium beschränkt. Gemäß einer besonders bevorzugten Weiterbildung ist es insbesondere möglich, dass der Sensor als Drucksensor vorgesehen ist und dass die Auswertung der Verformung der Membran piezoresistiv erfolgt, wobei mindestens ein piezoresistives Widerstandselement in den Bereich des monokristallinen Überhangs implantiert ist.

Die Erfindung ermöglicht des Weiteren, dass im monokristallinen Silizium der Epitaxieschicht, vorzugsweise außerhalb des Membran-Bereiches, ein oder mehrere elektronische Schaltungselemente und/oder Verdrahtungselemente integriert sind.

Ein Verfahren zur Herstellung eines erfindungsgemäßen mikromechanischen Bauelementes sieht vor,
- dass eine vorzugsweise aus Siliziumoxid bestehende Opferschicht auf dem Siliziumsubstrat abgeschieden und entsprechend dem späteren Membran-Bereich strukturiert wird,
- dass in einer Epitaxieanlage zu beiden Seiten der Opferschicht monokristallines Silizium selektiv auf das Siliziumsubstrat aufgewachsen wird, wobei diese monokristallinen Seitenbereiche bis in eine Höhe, die größer als die Dicke der Opferschicht ist, aufgewachsen werden,
- dass anschließend eine Epitaxieschicht aus Silizium abgeschieden wird, die oberhalb der Opferschicht polykristallin und oberhalb der monokristallin aufgewachsenen Seitenbereiche monokristallin aufwächst,
- wobei das sich bildende monokristalline Silizium von den Seitenbereichen aus schräg überhängend oberhalb des sich vom abgesenkten späteren Membran-Bereich aus bildenden polykristallinen Siliziums aufwächst,
- und dass zur Freilegung einer Silizium-Membran die Opferschicht unter der Epitaxieschicht durch einen Ätzprozess entfernt wird.

Durch den ersten Schritt dieses zweistufigen Epitaxie-Prozesses lässt sich demnach die oben erwähnte Umkehrung der Topografie erreichen, die im zweiten Epitaxieschritt dann zu den gewünschten monokristallinen Überhängen führt.

Eine besonders vorteilhafte Ausgestaltung des Verfahrens besteht darin, dass vor Erzeugen der Epitaxieschicht auf der Opferschicht eine Poly-Startschicht aufgebracht wird, wobei die monokristallinen Seitenbereiche bis in eine Höhe selektiv aufgewachsen werden, die größer als die aus der Dicke der Opferschicht und der Dicke der Poly-Startschicht zusammengesetzte Dicke ist.

Diese Ausgestaltung kann auf besonders einfache Weise implementiert werden, indem die Poly-Startschicht auf dem Siliziumsubstrat abgeschieden und indem die Poly-Startschicht auf den monokristallinen Seitenbereichen anschließend durch einen CMP-Schritt wieder entfernt wird.

Prozesstechnisch ist es gemäß einer anderen Weiterbildung des Verfahrens vorteilhaft, die Epitaxieschicht ohne eine gesondert aufzubringende Poly-Startschicht, entweder nur durch Umstellung der Verfahrensparameter von einem selektiven zu einem nichtselektiven Regime oder durch die im nichtselektiven Regime mögliche Erzeugung einer in situ Poly-Startschicht, zu erzeugen.

In den Unteransprüchen finden sich weitere vorteilhafte Weiterbildungen und Verbesserungen des in Anspruch 5 angegebenen Herstellungsverfahrens.

Das erfindungsgemäße Verfahren kann vorteilhafterweise mit rein oberflächenmikromechanischen Prozessschritten verwirklicht werden. Nur zwei Masken sind erforderlich: am Beginn des Prozesses zu Strukturierung der Opferschicht und später zur Herstellung der für die Freilegung der Membran notwendigen Ätzöffnungen. Durch die vorweg durchgeführte Herstellung der mikromechanischen Strukturen kann das Verfahren ohne weiteres mit den üblichen back end CMOS-Prozessen kombiniert werden. Die Unabhängigkeit der mikromechanischen und der CMOS-Prozesse verhindert eine unerwünschte Bindung an spezifische CMOS-Prozesse. Die Dicke der Membran ist präzise kontrollierbar bzw. einstellbar. Die Epitaxie-Anlage kann in einem weiten Druckbereich gefahren werden.

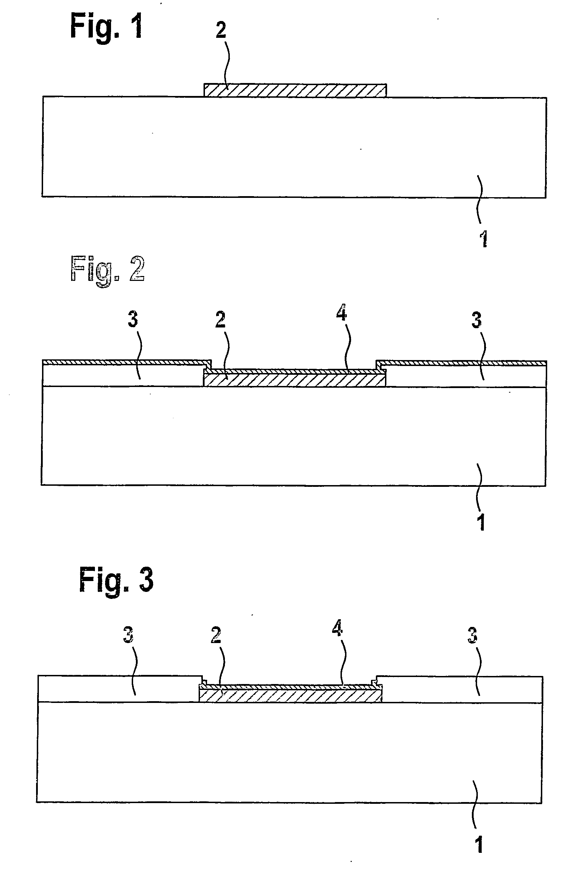

Ein Ausführungsbeispiel der Erfindung ist in den Figuren der Zeichnung dargestellt und in der nachfolgenden Beschreibung näher erläutert. Es zeigt
Figur 1 bis 7 einen Schnitt eines erfindungsgemäßen Bauelementes in verschiedenen Herstellungsphasen.

Figur 1 zeigt ein Siliziumsubstrat 1, auf dem bereits eine beispielsweise aus Siliziumdioxid bestehende Opferschicht 2 in an sich bekannter Weise abgeschieden und strukturiert wurde.

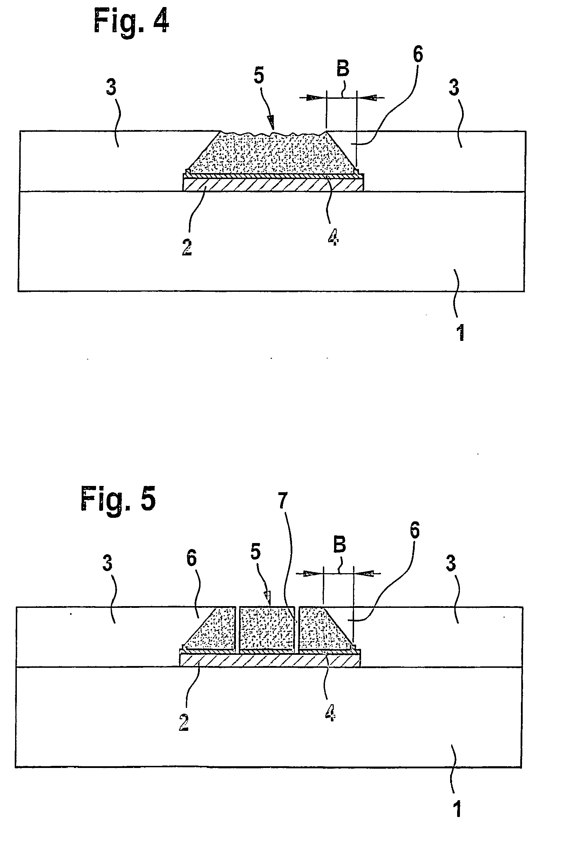

Figur 2 zeigt zusätzliche monokristalline Seitenbereiche 3, die zu beiden Seiten der Opferschicht 2 durch selektive Epitaxie, also oberhalb des Substrats 1, aufgewachsen wurden. Die selektive Epitaxie ist ein an sich bekanntes Verfahren, bei dem auf der Opferschicht 2 kein Silizium aufwächst. Das in Figur 2 angedeutete leichte Überkragen der Seitenbereiche 3 über die Opferschicht 2 kommt durch laterales Silizium-Wachstum an den weiter wachsenden Seitenbereichen 3, sobald diese die Dicke der Opferschicht 2 erreicht haben, zustande. Dieses Überkragen ist nicht ursächlich für das in Figur 4 dargestellte epitaktische Wachstum mit schrägem Profil und beruht auch auf einem anderen Entstehungs-Mechanismus als das schräge Profil dort. Davon abgesehen, ist es, sofern aus anderen Gründen erwünscht, möglich, das Ausmaß des Überkragens in relativ weiten Umfang mittels der Prozessparameter einzustellen.

Der wesentliche Schritt gemäß Figur 2 ist die Umkehrung der Topografie gegenüber Figur 1: die Höhe der Seitenbereiche 3 ist größer als die Dicke der Opferschicht 2, so dass diese sich gegenüber den monokristallinen Seitenbereichen 3 in einer abgesenkten Position ("recess") befindet. Auch wenn, wie in Figur 2 dargestellt, eine polykristalline Startschicht 4, welche vorzugsweise durch LPCVD abgeschieden wird, oberhalb der Opferschicht 2 und der Seitenbereiche 3 erzeugt wird, soll diese Topografie beibehalten werden, d. h. die Höhe der Seitenbereiche 3 ist auch in diesem Fall größer als die summierten Dicken von Opferschicht 2 und Poly-Startschicht 4 im Membran-Bereich 5 und 6.

Figur 3 zeigt das Prozessstadium nach Entfernen der oberhalb der monokristallinen Seitenbereiche 3 befindlichen Bereiche der Poly-Startschicht 4, welche vorzugsweise durch einen CMP (chemical mechanical polishing)-Prozess eliminiert werden.

Die Strukturierung der Poly-Startschicht 4 erfolgt demnach, wie bei Figur 3 beschrieben, vorteilhaft in selbstzentrierter Weise; die Poly-Startschicht 4 kann jedoch ebenso mit Hilfe einer zusätzlichen Maske strukturiert werden. Hierbei kann der polykristalline Bereich der Startschicht 4 oberhalb der Opferschicht 2 mit einer Schutzschicht (nicht dargestellt) geschützt sein, derart, dass eine Oxid- oder Nitrid-Schutzschicht aufgebracht und mit einem Photolithografieschritt mit einer anschließenden Ätzung über den Seitenbereichen 3 und einem schmalen, äußersten Saum im Randbereich der Opferschicht 2 entfernt wird. Danach kann die Poly-Startschicht 4 selektiv oberhalb der Seitenbereiche 3 durch Ätzung entfernt werden. Die Schutzschicht selbst (die gegebenenfalls auch vor einem CMP-Schritt eingesetzt werden kann) wird anschließend wieder entfernt.

Figur 4 zeigt das nächste Prozessstadium, nach dem in situ epitaktischen Aufwachsen von Silizium, das an den Seitenbereichen 3 (weiterhin) monokristallin, oberhalb der Poly-Startschicht 4 jedoch als polykristalliner Bereich 5 aufwächst. Das Wachstum der monokristallinen Bereiche 3 und des polykristallinen Bereiches 5 erfolgt dabei gleichzeitig und im Wesentlichen nebeneinander und mit ähnlicher Wachstumsrate. Vom höheren Niveau der Seitenbereiche 3 aus wächst das monokristalline Silizium lateral und vertikal, so dass aufgrund der Absenkung der Poly-Startschicht 4 ein laterales Überwachsen des monokristallinen Bereiches 3 über den polykristallinen Bereich 5 auftritt. Dies resultiert auf jeder Seite in der Bildung eines Überhangs 6, also einem monokristallinen Teilbereich in der Peripherie des späteren Membran-Bereiches 5 und 6. Die Übergangsbereiche zwischen monokristallinem und polykristallinem Silizium sind also quasi im Membran-Bereich 5 und 6 integriert statt, wie beim bekannten Bauelement mit epitaktischer Membran, in den Seitenbereichen 3 angeordnet.

Die Höhe des "recess" ist verantwortlich für die Breite "B", vgl. Figur 4, des Überhangs 6. Bei einer hohen Stufe, z. B. 4 µm, beträgt der Überhang 6 bis zu 12 µm bei einer Dicke der Epitaxieschicht 3 und 5 von etwa 10 µm.

Figur 5 zeigt das Verfahrensstadium nach Durchführen eines weiteren CMP-Schrittes um eine planare Oberfläche zu erhalten und nach Erzeugung von Ätzöffnungen 7, die beispielsweise einen Querschnitt von 5 x 5 µm aufweisen können und zwischen denen zunächst Teilstücke 8 der Membran 5 und 6 gebildet werden.

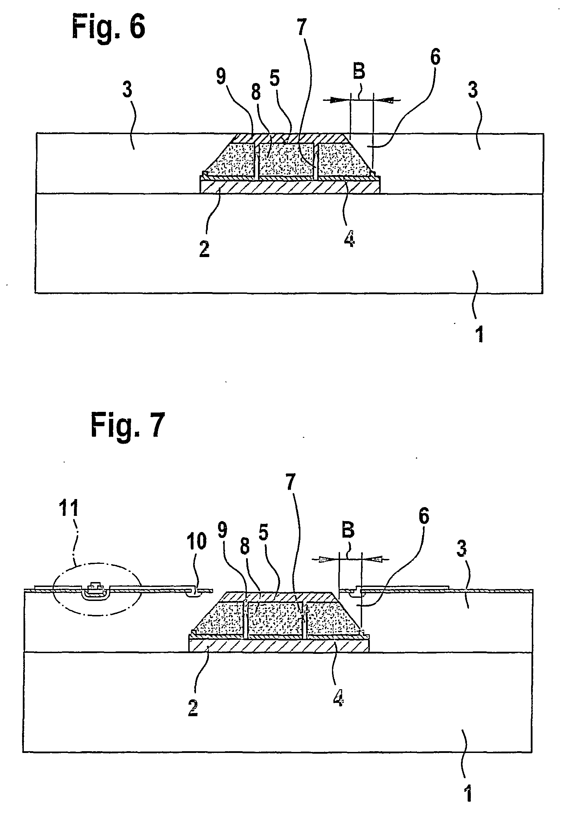

Figur 6 zeigt das Prozessstadium, in welchem durch einen Opferschicht-Ätzprozess, beispielsweise mittels HF-Dampf oder XeF₂ (für die Ätzung einer Opferschicht aus Polysilizium oder SiGe, zuvor muss dabei eine dünne Passivierungsschicht, z. B. Oxid oder Nitrid, abgeschieden werden, die dann aus den Ätzöffnungen 7 wieder entfernt werden muss), die Membran 5 und 6 vertikal freigelegt wurde. Statt der Opferschicht 2 ist nunmehr der Hohlraum unterhalb der Membran 5 und 6 vorhanden.

Erkennbar in Figur 6 ist auch ein Refill 9 der Ätzöffnungen 7, vorzugsweise mittels monokristallinem und polykristallinem epitaktischen Silizium-Wachstum, um die Planarität aufrechtzuerhalten. Möglich ist jedoch auch das Aufbringen einer planarisierenden Oxidschicht.

Anschließend können, wie in Figur 7 dargestellt, piezoresistive Widerstandselemente 10 ohne weiteres in den monokristallinen Überhang 6 implantiert werden. Danach kann, ebenfalls in monokristallinem Silizium, jedoch typischerweise außerhalb der Membran 5 und 6, die Herstellung von CMOS-Schaltungstrukturen 11 erfolgen.

Die zuvor beschriebene Si-Epitaxie zur Erzeugung der monokristallinen Seitenbereiche 3 kann durch Zuführung von Chlor zur Oberseite des Siliziumssubstrats 1 in an sich bekannter Weise in einem streng selektiven Regime durchgeführt werden. Die Zuführung von Chlor zur Einstellung der Selektivität der Epitaxieprozesse wird vorteilhaft durch Zuführung von HCl-Gas realisiert. Es ist zu beachten, dass, bei selektiver Prozessführung, epitaktisches Silizium nur auf Silizium, also nicht auf der nackten (Oxid)Opferschicht 2, in reproduzierbarer Weise aufgewachsen werden kann. Um dies bei der Erzeugung der Epitaxieschicht 3 und 5 zu gewährleisten, ist es, wie weiter oben beschrieben, bevorzugt, eine Poly-Startschicht 4 gesondert auf der Opferschicht 2 zu erzeugen.

Alternativ besteht jedoch auch die Möglichkeit, dass nach dem selektiven Regime, also nach der Fertigstellung der monokristallinen Seitenbereiche 3, durch Verringerung der Chlor-Zuführung ein nichtselektives Regime eingestellt wird, in welchem die Epitaxieschicht 3 und 5 auch oberhalb der Opferschicht 2 aufwächst.

Da dies im Allgemeinen mit einer Verschlechterung der Qualität in der Epitaxieschicht sowohl im monokristallinen wie im polykristallinen Bereich 3 bzw. 5 verknüpft ist, besteht in diesem Fall eine besonders bevorzugte Verfahrensführung darin, dass die Umstellung auf das nichtselektive Regime (nur) so lange erfolgt, bis durch polykristalline Bekeimung der Opferschicht 2 eine Poly-Startschicht 4 in situ hergestellt ist, und darin, dass die weitere Erzeugung der Epitaxieschicht 3 und 5 nach erneuter Umstellung auf das selektive Regime durchgeführt wird, so dass polykristallines Silizium oberhalb der in situ Poly-Startschicht 4 und monokristallines Silizium oberhalb der Seitenbereiche nebeneinander in einem Prozessschritt aufgewachsen werden.

Obwohl die vorliegende Erfindung vorstehend anhand eines bevorzugten Ausführungsbeispiels beschrieben wurde, ist sie darauf nicht beschränkt, sondern auf vielfältige Weise modifizierbar.

Beispielsweise können an sich bekannte, in den Figuren nicht dargestellte, weitere Prozessschritte vorgesehen werden, um insbesondere weitere Schaltungs- und/oder Verdrahtungsstrukturen zu realisieren.

Schließlich wurde in dem obigen Ausführungsbeispiel ein Drucksensor mit piezoresistiver Messwertaufnahme gezeigt, doch ist die Erfindung auch auf andere Sensoren und auf anderweitig verwendete epitaktische Membran-Strukturen anwendbar, bei denen die Messelemente 10 keine piezoresistiven Widerstandselemente bzw. gar nicht vorhanden sind.

## Patentansprüche

1. Mikromechanisches Bauelement, insbesondere Drucksensor, bestehend aus einem Siliziumsubstrat (1) mit einer darauf abgeschiedenen Epitaxieschicht (3, 5) mit nebeneinander aufgewachsenem monokristallinen und polykristallinen Silizium,
wobei durch einen Ätzprozess ein Bereich (5, 6) der Epitaxieschicht (3, 5) als vertikal auslenkbare Membran freigelegt ist,
wobei die Epitaxieschicht (3, 5) in einem etwa dem Membran-Bereich (5, 6) entsprechenden Bereich aus polykristallinem Silizium besteht, das zu beiden Seiten der Membran in monokristallines Silizium übergeht, wodurch Übergangsbereiche gebildet sind,
wobei die Übergangsbereiche von polykristallinem zu monokristallinem Silizium jeweils ein schräges Profil aufweisen, derart, dass sich das monokristalline Silizium in Form eines Überhangs (6) oberhalb des polykristallinen Siliziums in den Membran-Bereich (5, 6) hinein erstreckt,
**dadurch gekennzeichnet, dass**
das Bauelement als Sensor ausgebildet ist und dass Mittel zur Auswertung der Auslenkung der Membran vorgesehen sind,
wobei mindestens ein Messelement zur Messung der Auslenkung an der Membranoberseite, im Bereich des monokristallinen Überhangs (6), angeordnet ist.

2. Mikromechanisches Bauelement nach Anspruch 1,
**dadurch gekennzeichnet, dass** der Sensor als Drucksensor vorgesehen ist und dass die Auswertung der Verformung der Membran piezoresistiv erfolgt, wobei mindestens ein piezoresistives Widerstandselement (10) in den Bereich des monokristallinen Überhangs (6) implantiert ist.

3. Mikromechanisches Bauelement nach einem der Ansprüche 1 oder 2,
**dadurch gekennzeichnet, dass** im monokristallinen Silizium der Epitaxieschicht (3, 5), vorzugsweise außerhalb des Membran-Bereiches (5, 6), ein oder mehrere elektronische Schaltungselemente (1 1) und/oder Verdrahtungselemente integriert sind.

4. Verfahren zur Herstellung des mikromechanischen Bauelementes nach einem der Ansprüche 1 bis 3, **dadurch gekennzeichnet,**
- **dass** eine vorzugsweise aus Siliziumoxid bestehende Opferschicht (2) auf dem Siliziumsubstrat (1) abgeschieden und entsprechend dem späteren Membran-Bereich (5, 6) strukturiert wird,
- **dass** in einer Epitaxieanlage zu beiden Seiten der Opferschicht (2) monokristallines Silizium selektiv auf das Siliziumsubstrat (1) aufgewachsen wird, wobei diese monokristallinen Seitenbereiche (3) bis in eine Höhe, die größer als die Dicke der Opferschicht (2) ist, aufgewachsen werden,
- **dass** anschließend eine Epitaxieschicht (3, 5) aus Silizium abgeschieden wird, die oberhalb der Opferschicht (2) polykristallin und oberhalb der monokristallin aufgewachsenen Seitenbereiche (3) monokristallin aufwächst,
- wobei das sich bildende monokristalline Silizium von den Seitenbereichen (3) aus schräg überhängend oberhalb des sich vom abgesenkten späteren Membran-Bereich (5, 6) aus bildenden polykristallinen Siliziums aufwächst,
- und **dass** zur Freilegung einer Silizium-Membran die Opferschicht (2) unter der Epitaxieschicht (3, 5) durch einen Ätzprozess entfernt wird.

5. Verfahren nach Anspruch 4,
**dadurch gekennzeichnet, dass** vor Erzeugen der Epitaxieschicht (3, 5) auf der Opferschicht (2) eine Poly-Startschicht (4) aufgebracht wird, wobei die monokristallinen Seitenbereiche (3) bis in eine Höhe selektiv aufgewachsen werden, die größer als die aus der Dicke der Opferschicht (2) und der Dicke der Poly-Startschicht (4) zusammengesetzte Dicke ist.

6. Verfahren nach Anspruch 5,
**dadurch gekennzeichnet, dass** die Poly-Startschicht (4) auf dem Siliziumsubstrat (1) abgeschieden und dass die Poly-Startschicht (4) auf den monokristallinen Seitenbereichen (3) anschließend durch einen CMP-Schritt wieder entfernt wird.

7. Verfahren nach einem der Ansprüche 4 bis 6,
**dadurch gekennzeichnet, dass** die Si-Epitaxie zur Erzeugung der monokristallinen Seitenbereiche (3) durch Zuführung von Chlor zur Oberseite des Siliziumssubstrats (1) in einem streng selektiven Regime durchgeführt wird.

8. Verfahren nach Anspruch 7,
**dadurch gekennzeichnet, dass** nach dem selektiven Regime durch Verringerung der Chlor-Zuführung ein nichtselektives Regime eingestellt wird, in welchem die Epitaxieschicht (3, 5) auch oberhalb der Opferschicht (2) aufwächst.

9. Verfahren nach Anspruch 8,
**dadurch gekennzeichnet, dass** die Umstellung auf das nichtselektive Regime so lange erfolgt, bis durch polykristalline Bekeimung der Opferschicht (2) eine Poly-Startschicht (4) in situ hergestellt ist, und dass die weitere Erzeugung der Epitaxieschicht (3, 5) nach erneuter Umstellung auf das selektive Regime durchgeführt wird, so dass polykristallines Silizium oberhalb der in situ Poly-Startschicht (4) und monokristallines Silizium oberhalb der Seitenbereiche (3) nebeneinander in einem Prozessschritt aufgewachsen werden.

10. Verfahren nach einem der Ansprüche 4 bis 9,
**dadurch gekennzeichnet, dass** die Zuführung von Chlor zur Einstellung der Selektivität der Epitaxieprozesse durch Zuführung von HCl-Gas realisiert wird.

## Claims

1. Micromechanical component, in particular pressure sensor, comprising a silicon substrate (1) on which is deposited an epitaxial layer (3, 5) with monocrystalline and polycrystalline silicon grown next to one another,
an etching process uncovering a region (5, 6) of the epitaxial layer (3, 5) as a vertically deflectable membrane,
the epitaxial layer (3, 5), in a region which approximately corresponds to the membrane region (5, 6), consisting of polycrystalline silicon, which merges on both sides of the membrane into monocrystalline silicon, resulting in the formation of transition regions,
the transition regions from polycrystalline silicon to monocrystalline silicon each having an oblique profile, in such a manner that the monocrystalline silicon extends into the membrane region (5, 6) in the form of an overhang (6) above the polycrystalline silicon,
**characterized in that**
the component is designed as a sensor and **in that** there are means for evaluating the deflection of the membrane,
at least one measurement element for measuring the deflection being arranged on the membrane top side, in the region of the monocrystalline overhang (6).

2. Micromechanical component according to Claim 1, **characterized in that** the sensor is provided as a pressure sensor, and **in that** the evaluation of the deformation of the membrane takes place piezo-resistively, at least one piezo-resistive resistance element (10) being implanted in the region of the monocrystalline overhang (6).

3. Micromechanical component according to either of Claims 1 and 2, **characterized in that** one or more electronic circuit elements (11) and/or wiring elements are integrated in the monocrystalline silicon of the epitaxial layer (3, 5), preferably outside the membrane region (5, 6).

4. Process for producing the micromechanical component according to one of Claims 1 to 3,
**characterized**
- **in that** a sacrificial layer (2), preferably consisting of silicon oxide, is deposited on the silicon substrate (1) and is structured so as to match the subsequent membrane region (5, 6),
- **in that** in an epitaxy installation monocrystalline silicon is grown selectively on the silicon substrate (1) on both sides of the sacrificial layer (2), these monocrystalline side regions (3) being grown to a height which is greater than the thickness of the sacrificial layer (2),
- **in that** then an epitaxial layer (3, 5) of silicon is deposited, this layer growing in polycrystalline form above the sacrificial layer (2) and in monocrystalline form above the side regions (3) which have been grown in monocrystalline form,
- the monocrystalline silicon which forms growing obliquely from the side regions (3) so as to overhang above the polycrystalline silicon which forms from the recessed subsequent membrane region (5, 6),
- and **in that** to uncover a silicon membrane, the sacrificial layer (2) beneath the epitaxial layer (3, 5) is removed by an etching process.

5. Process according to Claim 4, **characterized in that** prior to the production of the epitaxial layer (3, 5), a poly starting layer (4) is applied to the sacrificial layer (2), the monocrystalline side regions (3) being grown selectively to a height which is greater than the combined thickness of the sacrificial layer (2) and the poly starting layer (4).

6. Process according to Claim 5, **characterized in that** the poly starting layer (4) is deposited on the silicon substrate (1), and **in that** the poly starting layer (4) on the monocrystalline side regions (3) is then removed again by a CMP step.

7. Process according to one of Claims 4 to 6, **characterized in that** the Si epitaxy used to produce the monocrystalline side regions (3) is carried out in a highly selective regime by supplying chlorine to the top side of the silicon substrate (1).

8. Process according to Claim 7, **characterized in that** following the selective regime, a nonselective regime, in which the epitaxial layer (3, 5) also grows above the sacrificial layer (2), is set by reducing the supply of chlorine.

9. Process according to Claim 8, **characterized in that** the switch to the nonselective regime continues until a poly starting layer (4) has been produced in situ by polycrystalline nucleation of the sacrificial layer (2), and **in that** the further production of the epitaxial layer (3, 5) has been carried out after switching back to the selective regime, so that polycrystalline silicon is grown above the in-situ poly starting layer (4) and monocrystalline silicon is grown above the side regions (3), next to one another in one process step.

10. Process according to one of Claims 4 to 9, **characterized in that** the supply of chlorine for setting the selectivity of the epitaxy processes is realized by the supply of HCl gas.

## Revendications

1. Composant micromécanique, en particulier capteur de pression, constitué d'un substrat en silicium (1) sur lequel une couche épitaxiale (3, 5) est déposée avec croissance de silicium monocristallin et de silicium polycristallin l'un près de l'autre,
dans lequel une zone (5, 6) de la couche épitaxiale (3, 5) est dégagée par un procédé d'attaque pour former une membrane que l'on peut dévier verticalement,
la couche épitaxiale (3, 5) est constituée, dans une zone correspondant approximativement à la zone de membrane (5, 6), de silicium polycristallin qui se transforme des deux côtés de la membrane en silicium monocristallin, moyennant quoi se forment des zones de transition,
les zones de transition du silicium polycristallin au silicium monocristallin présentent chacune un profil incliné de telle façon que le silicium monocristallin s'étend dans la zone de membrane (5, 6) sous la forme d'un porte-à-faux (6) au-dessus du silicium polycristallin,
**caractérisé en ce que**
le composant est un capteur avec des moyens d'exploitation de la déviation de la membrane, et
au moins un élément de mesure de la déviation est monté sur la face supérieure de la membrane dans la zone du porte-à-faux monocristallin (6)

2. Composant micromécanique selon la revendication 1,
**caractérisé en ce que**
le capteur est un capteur de pression et l'exploitation de la déformation de la membrane est effectuée de façon piézorésistive, au moins un élément piézorésistif (10) étant implanté dans la zone du porte-à-faux monocristallin (6).

3. Composant micromécanique selon l'une quelconque des revendications 1 ou 2,
**caractérisé en ce qu'**
un ou plusieurs éléments électroniques de circuit (11) et/ou éléments de câblage sont intégrés dans le silicium monocristallin de la couche épitaxiale (3,5), de préférence en dehors de la zone de membrane (5, 6).

4. Procédé de fabrication du composant micromécanique selon l'une quelconque des revendications 1 à 3,
**caractérisé en ce que**
- on dépose une couche sacrificielle (2), constituée de préférence d'oxyde de silicium, sur un substrat en silicium (1) et on la structure selon la future zone de membrane (5, 6),
- du silicium monocristallin présente une croissance sélective sur le substrat en silicium (1) dans un agencement épitaxial des deux côtés de la couche sacrificielle (2), ces zones latérales monocristallines (3) croissant jusqu'à une hauteur qui est supérieure à l'épaisseur de la couche sacrificielle (2),
- on dépose ensuite une couche épitaxiale (3, 5) en silicium dont la croissance est polycristalline au-dessus de la couche sacrificielle (2) et monocristalline au-dessus des zones latérales (3) à croissance monocristalline,
- le silicium monocristallin qui se forme présente une croissance à partir des zones latérales (3) en porte-à-faux incliné au-dessus du silicium polycristallin qui se forme à partir de la future zone de membrane (5, 6) abaissée,
- et, pour dégager une membrane en silicium, on enlève la couche sacrificielle (2) sous la couche épitaxiale (3, 5) par un procédé d'attaque.

5. Procédé selon la revendication 4,
**caractérisé en ce qu'**
avant la réalisation de la couche épitaxiale (3, 5), on applique sur la couche sacrificielle (2) une couche de départ polycristalline (4), les zones latérales monocristallines (3) présentant une croissance sélective jusqu'à une hauteur supérieure à l'épaisseur composée de l'épaisseur de la couche sacrificielle (2) et de celle de la couche de départ polycristalline (4).

6. Procédé selon la revendication 5,
**caractérisé en ce qu'**
on dépose la couche de départ polycristalline (4) sur le substrat en silicium (1), puis on la retire sur les zones latérales monocristallines (3) par une étape de polissage chimique et mécanique.

7. Procédé selon l'une quelconque des revendications 4 à 6,
**caractérisé en ce que**
l'épitaxie sur Si est réalisée pour produire les zones latérales monocristallines (3) par amenée de chlore sur la face supérieure du substrat en silicium (1) par un régime strictement sélectif.

8. Procédé selon la revendication 7,
**caractérisé en ce que**
après le régime sélectif, on établit par réduction de l'amenée de chlore un régime non sélectif dans lequel la croissance de la couche épitaxiale (3, 5) se produit également au-dessus de la couche sacrificielle (2).

9. Procédé selon la revendication 8,
**caractérisé en ce que**
le passage au régime non sélectif s'effectue jusqu'à ce qu'une couche de départ polycristalline (4) soit formée in situ par germination polycristalline de la couche sacrificielle (2) et la suite de la production de la couche épitaxiale (3, 5) est réalisée après nouveau passage au régime sélectif, de sorte qu'au cours d'une étape du procédé le silicium polycristallin présente une croissance au-dessus de la couche de départ polycristalline (4) formée in situ, près du silicium monocristallin présentant une croissance au-dessus des zones latérales (3).

10. Procédé selon l'une quelconque des revendications 4 à 9,
**caractérisé en ce que**
l'amenée de chlore pour établir la sélectivité des processus d'épitaxie est une amenée de HCl gazeux.
